# DEMANDE DE BREVET EUROPEEN

(11) **EP 1 959 490 A1**
(43) Date de publication de la demande: **20.08.2008**
(21) Numéro de dépôt: 08101631.3
(22) Date de dépôt: 14.02.2008
(51) Int. Cl.: H01L 21/762

(54) **Procédé de fabrication d'une structure de type semiconducteur sur isolant**

(30) Priorité: 15.02.2007 FR 0753287
(71) Demandeur: STMicroelectronics SA, 92120 Montrouge (FR); STMicroeletronics Crolles 2 SAS, 38920 Crolles (FR)
(72) Inventeur: Halimaoui, Aomar, 38660, La Terrasse (FR); Morand, Yves, 38000, Grenoble (FR); Campidelli Yves, 38000, Grenoble (FR); Kermarrec, Olivier, 38610, Gieres (FR)
(74) Mandataire: de Beaumont, Michel

(57) **Abrégé**

L'invention concerne un procédé de fabrication d'une couche semiconductrice isolée comprenant les étapes suivantes : former une couche de silicium poreux sur une surface de silicium monocristallin (1) ; déposer un matériau isolant (5) de sorte qu'il pénètre dans les pores de la couche de silicium poreux ; éliminer le matériau isolant jusqu'à exposer la surface supérieure du silicium poreux ; et faire croître par épitaxie une couche semiconductrice (11).

## Description

### Domaine de l'invention

La présente invention concerne de façon générale des composants semiconducteurs, et plus particulièrement un procédé de fabrication d'un substrat de type semiconducteur sur isolant. La présente invention concerne également la structure obtenue par ce procédé.

### Exposé de l'art antérieur

Divers procédés de fabrication de structures de type silicium sur isolant (SOI) sont connus.

Un premier procédé consiste à utiliser deux plaquettes de silicium dont l'une possède une face oxydée, et à les coller de façon que la face oxydée soit située entre les deux plaquettes. On réalise ensuite une gravure, ou toute autre opération chimique ou mécanique, pour réduire la surface d'une plaquette et obtenir ainsi la structure SOI désirée. Ce procédé est relativement fiable, mais il est limité par le fait qu'il permet uniquement de réaliser des structures SOI pleine plaque.

Un autre procédé consiste à créer, sur une plaque de silicium monocristallin, une couche d'isolant possédant une ouverture. Une épitaxie de silicium est alors réalisée sur ce système et permet de former, au niveau de l'ouverture, une portion de silicium monocristallin et, sur la couche d'isolant, une couche de silicium polycristallin. Une étape de recristallisation transforme l'ensemble de la couche en silicium monocristallin. Ce procédé permet la localisation de zones de SOI sur une plaquette de silicium mais n'est pas très fiable et ne permet pas d'obtenir des zones de SOI étendues.

### Résumé de l'invention

La présente invention a pour but de proposer un nouveau procédé d'obtention d'une structure de type semiconducteur sur isolant sur un support de silicium. Ce procédé permet en outre de localiser la structure de type semiconducteur sur isolant sur le support.

Pour atteindre tout ou partie de ces objets ainsi que d'autres, un mode de réalisation de la présente invention prévoit un procédé de fabrication d'une couche semiconductrice isolée comprenant les étapes suivantes : former une couche de silicium poreux sur une surface de silicium monocristallin ; déposer un matériau isolant de sorte qu'il pénètre dans les pores de la couche de silicium poreux ; éliminer le matériau isolant jusqu'à exposer la surface supérieure du silicium poreux ; et faire croître par épitaxie une couche semiconductrice.

Selon un mode de réalisation de la présente invention, le matériau de la couche semiconductrice est choisi dans le groupe comprenant le silicium, le germanium et le silicium-germanium.

Selon un mode de réalisation de la présente invention, la couche de silicium poreux est formée par attaque électrochimique de la surface de silicium monocristallin.

Selon un mode de réalisation de la présente invention, le matériau isolant est du HfO₂ ou autre isolant pouvant être déposé par un procédé dit de dépôt ALD (Atomic Layer Deposition).

Un mode de réalisation de la présente invention prévoit une structure de type semiconducteur sur isolant comprenant une couche semiconductrice reposant sur une couche de silicium poreux dont les pores sont remplis d'un matériau isolant, la couche de silicium poreux reposant sur du silicium monocristallin.

Selon un mode de réalisation de la présente invention, le matériau de la couche semiconductrice est choisi dans le groupe comprenant le silicium, le germanium et le silicium-germanium.

Selon un mode de réalisation de la présente invention, le matériau isolant est du HfO₂.

Un mode de réalisation de la présente invention concerne également une structure de type semiconducteur sur isolant formée à au moins un emplacement d'une plaquette de silicium.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
les figures 1A à 1D représentent les résultats d'étapes d'un procédé de fabrication selon un mode de réalisation de l'invention d'une structure de type semiconducteur sur isolant ; et
la figure 2 représente une portion de plaquette de silicium comprenant une zone localisée de type semiconducteur sur isolant, selon un mode de réalisation de l'invention.

### Description détaillée

Par souci de clarté, de mêmes éléments ont été désignés par de mêmes références aux différentes figures et, de plus, comme cela est habituel dans la représentation des composants semiconducteurs, les diverses figures ne sont pas tracées à l'échelle.

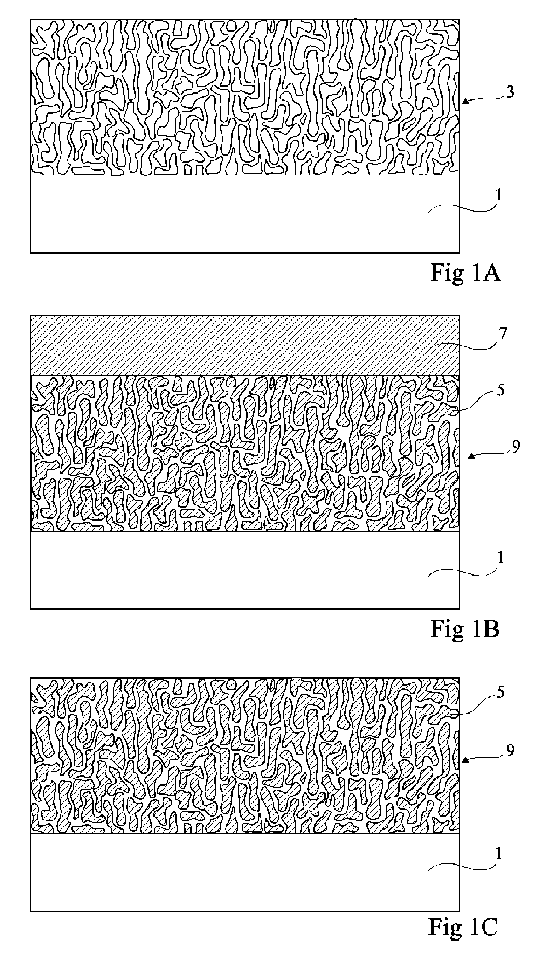

La figure 1A représente une plaquette de silicium 1 dont la face supérieure a été transformée au moins localement en silicium poreux 3 par tout procédé connu, par exemple par électrolyse en présence d'une solution acide.

A l'étape de la figure 1B, on a effectué un dépôt d'un matériau isolant par un procédé couramment désigné dans la technique par le sigle ALD sur la structure de la figure 1A. Lors de cette étape, les pores du silicium poreux sont remplis par le matériau isolant 5 et du matériau isolant se dépose en une couche 7 au-dessus de la structure. Ces procédés impliquent de préférence une étape, au moins initiale, d'oxydation superficielle du silicium poreux. A titre d'exemple, le matériau isolant peut être du dioxyde d'hafnium HfO₂ obtenu par une alternance de cycles en atmosphère de HfCl₄ et en atmosphère de H₂O. Du fait du remplissage des pores du silicium poreux 3 isolant par le matériau isolant 5, le caractère isolant de la couche 9 obtenue augmente de façon importante.

A l'étape de la figure 1C, on a effectué un retrait de la couche de matériau isolant 7 située au-dessus de la couche 9. Ce retrait permet de faire apparaître la surface supérieure des grains de la couche 9 de silicium poreux dont les pores ont été remplis du matériau isolant 5. A titre d'exemple, ce retrait peut être effectué par gravure chimique ou par un procédé CMP (Polissage Mécano Chimique), ou par une combinaison de ces deux opérations.

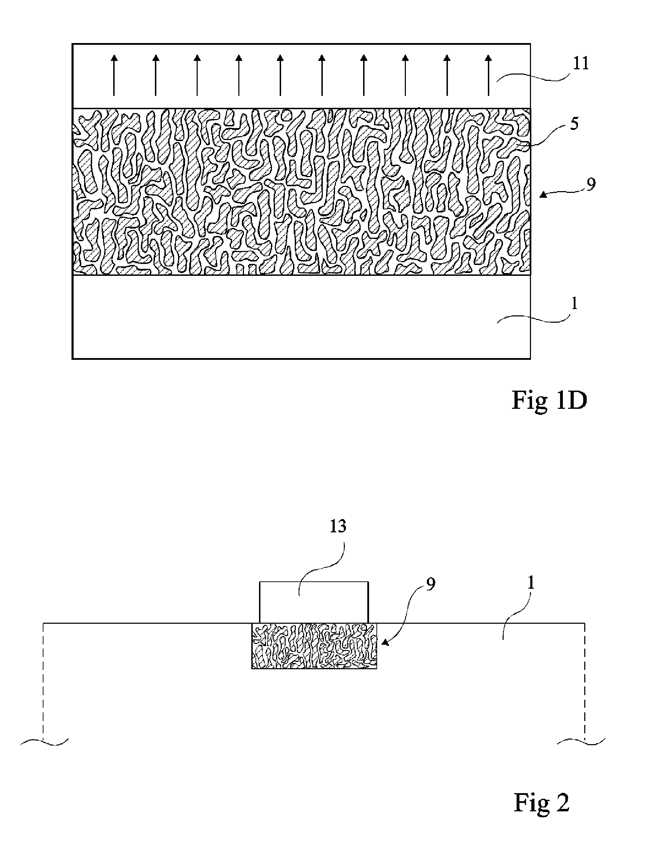

A l'étape de la figure 1D, on a effectué une croissance par épitaxie d'une couche de semiconducteur 11 sur la structure de la figure 1C. Cette croissance est possible puisque l'information cristallographique du silicium 1 est conservée dans les grains de silicium poreux de la couche 9. A titre d'exemple, la couche de semiconducteur 11 peut être une couche de silicium, de germanium ou de silicium-germanium.

On a donc obtenu par ce procédé une structure de type semi-conducteur sur isolant, l'isolant étant la couche 9 de silicium poreux dont les pores sont remplis d'isolant 5.

La figure 2 illustre une portion de plaquette de silicium 1 sur laquelle on a réalisé une zone 13 de type semiconducteur sur isolant selon un mode de réalisation de l'invention. En effet, le procédé de l'invention présente l'avantage de permettre, par un système de masquage adapté, de réaliser les opérations décrites en relation avec les figures 1A à 1D uniquement sur des zones choisies d'une plaquette de silicium 1.

Des modes de réalisation particuliers de la présente invention ont été décrits. Diverses variantes et modifications apparaîtront à l'homme de l'art. En particulier, le matériau isolant 5, 7 a été décrit comme étant du HfO₂. A titre de variante, ce matériau isolant peut être tout matériau isolant pouvant être déposé par un procédé ALD ou autre procédé permettant un remplissage des pores d'une couche de silicium poreux, par exemple divers procédés de dépôt chimique en phase vapeur (CVD), éventuellement assistés par plasma, utilisés dans des conditions de faible cinétique.

Le procédé de fabrication selon un mode de réalisation de la présente invention présente plusieurs avantages par rapport aux procédés connus :
- ce procédé permet, comme cela a été décrit en relation avec la figure 2, de localiser une structure de type semiconducteur sur isolant sur une plaquette de silicium ;
- ce procédé permet de créer, sur une même plaquette, des zones de silicium, de silicium sur isolant, de germanium sur isolant, de silicium-germanium sur isolant... ;
- ce procédé permet également d'obtenir un isolant très stable à des températures élevées. En effet, l'association du silicium poreux avec un matériau isolant de type dioxyde d'hafnium HfO₂ forme un matériau résistant aux températures élevées. De plus, ce matériau a la propriété de ne pas se consommer dans les acides, c'est-à-dire que l'utilisation de procédés mettant en oeuvre des acides est possible pour former des composants à partir de la structure de la figure 2D ;
- la couche de semiconducteur 11 est obtenue par une épitaxie, qui est un procédé bien maîtrisé. Le procédé de l'invention permet donc de réaliser des structures de type semiconducteur sur isolant munies d'une couche semiconductrice d'épaisseur contrôlée.

A titre d'exemple de valeurs numériques, le procédé de fabrication d'une structure de type semiconducteur sur isolant de l'invention permet d'obtenir une couche de silicium poreux 9 sur une profondeur d'environ 500 nm et dont les pores ont des dimensions d'environ 5 nm.

## Revendications

1. Procédé de fabrication d'une couche semiconductrice isolée comprenant les étapes suivantes :
former une couche de silicium poreux (3) sur une surface de silicium monocristallin (1) ;
déposer un matériau isolant (5, 7) de sorte qu'il pénètre dans les pores de la couche de silicium poreux (3) ;
éliminer le matériau isolant (7) jusqu'à exposer la surface supérieure du silicium poreux ; et
faire croître par épitaxie une couche semiconductrice (11).

2. Procédé selon la revendication 1, dans lequel le matériau de la couche semiconductrice (11) est choisi dans le groupe comprenant le silicium, le germanium et le silicium-germanium.

3. Procédé selon la revendication 1, dans lequel la couche de silicium poreux (3) est formée par attaque électrochimique de la surface de silicium monocristallin (1).

4. Procédé selon la revendication 1, dans lequel le matériau isolant (5, 7) est du HfO₂ ou autre isolant pouvant être déposé par un procédé dit de dépôt ALD.

5. Structure de type semiconducteur sur isolant comprenant une couche semiconductrice (11) reposant sur une couche (9) de silicium poreux dont les pores sont remplis d'un matériau isolant (5), la couche de silicium poreux reposant sur du silicium monocristallin (1).

6. Structure selon la revendication 5, dans laquelle le matériau de la couche semiconductrice (11) est choisi dans le groupe comprenant le silicium, le germanium et le silicium-germanium.

7. Structure selon la revendication 5, dans laquelle le matériau isolant (5) est du HfO₂.

8. Structure de type semiconducteur sur isolant selon la revendication 5 formée à au moins un emplacement d'une plaquette de silicium.
